Europäisches Patentamt

European Patent Office

Office européen des brevets

(11) Publication number: **0 264 650 B1**

# EUROPEAN PATENT SPECIFICATION

(45) Date of publication of patent specification: **26.08.92**  (51) Int. Cl.⁵: **G03F 7/09**

(21) Application number: **87113957.2**

(22) Date of filing: **13.04.84**

(60) Publication number of the earlier application in accordance with Art.76 EPC: **0 159 428**

(54) **Anti-reflective coating.**

(43) Date of publication of application:
**27.04.88 Bulletin   88/17**

(45) Publication of the grant of the patent:
**26.08.92 Bulletin   92/35**

(84) Designated Contracting States:
**DE FR GB IT NL**

(56) References cited:
**DE-A- 1 622 302
GB-A- 2 085 609
US-A- 4 362 809
US-A- 4 370 405**

**IBM TECHNICAL DISCLOSURE BULLETIN, vol. 23, no. 7B, December 1980, pages 3387-3390, New York, US; E. BASSOUS et al.: "Acridine and acridine derivatives in photoresist: application as deep UV mask materials for high resolution microlithography"**

(73) Proprietor: **Brewer Science, Inc.
P.O. Box GG
Rolla Missouri 65401(US)**

(72) Inventor: **Arnold, John W.
1811 Forum Drive
Rolla Missouri 65401(US)**
Inventor: **Brewer, Terry L.
Route 2, Box 495
Rolla Missouri 65401(US)**
Inventor: **Punyakumleard, Sumalee
241 Nagogami Terrace
Rolla Missouri 65401(US)**

(74) Representative: **Tubby, David George et al
MARKS & CLERK 57-60 Lincoln's Inn Fields
London WC2A 3LS(GB)**

## Description

The present invention relates to a photolithographic resist having a novel anti-reflective coating, and to processes for producing such a photolithographic resist and integrated circuit elements using such a resist, as well as to a novel composition useful in the production of such a photolithographic resist.

The miniaturizing of systems utilizing complex integrated circuits has required that increasingly complex circuitry be imprinted on chips of decreasing size. This reduction in size, or increase in volumetric capacity, has reached the point where the techniques available to the industry have been stretched to the limit of their capabilities. As it is, the yield of the most advanced integrated circuit chips produced by standard techniques is extremely low, of the order of 1%, due to attempts to put more and more capacity into a smaller and smaller volume. At the level of capacity which is being demanded by the industry today, the current photolithographic processes cannot produce a complete, workable structure more than about 1% of the time.

The problem is due to a large extent to the limitations of the photographic process used. At the microscopic level which is required, the layers of chip material, silicon, for example, are not perfectly smooth and flat. Moreover, the uneven topography is of a magnitude approximating that of the wavelength of the light which is used to form the images in the photoresistive material which is applied to the layers of the chip. The light which is used to image the photoresistive material is reflected from the substrate of the chip material, that is, the silicon wafer. This reflection, coupled with the uneven topography, causes an uneven distribution of light in the imageable material and results in a large number of artifacts being produced in the developed image. These artifacts cause a large number of rejects in any semi-conductor structure built by current techniques.

It is apparent that if artifacts can be eliminated or reduced the yield of integrated circuit chips can be increased, resulting in great efficiency and reducing the cost of producing such materials.

Recently there have been a number of attempts to reduce the artifacts caused by reflected light. U.S. Patent No. 4,102,683 discusses one such attempt. Other discussions appear in the IEEE Transactions on Electron Devices, Edition 28, No. 11 of November 1981, pages 1405 to 1410, entitled "Line Width Control and Projection Lithography Using a Multi-Layer Resist Process" by O'Toole, et al. and in "Reduction of the Standing Wave Effect in Positive Photo-Resist," Brewer, et al. in Journal of Applied Photographic Engineering, Vol. 7, No. 6, Dec. 1981, pages 184 to 186, and "Control of One-Micron Lines in Integrated Circuits," Carlson, et al., Kodak, '80 Interface, October 1980, pages 109 to 113.

US-A-4 370 405 discloses a multi-layer resist of the type to which the present invention relates. In the embodiment of this prior art described in column 2 of that patent, there is a resist comprising a substrate on which is deposited a bottom layer "of sufficient thickness (approximately 1.5 micron) to produce a planar top surface". This bottom layer, whose thickness in SI units is 1.5$\mu$m, may contain a dye to reduce reflections, and thus corresponds to the anti-reflective coating of the present invention. On this bottom layer there is supported a "thin" (about 0.1$\mu$m) silicon nitride layer, and this, in turn, supports a "thin" (about 0.5$\mu$m) layer of a resist. The elements of the prior resist thus correspond generally to those of the present invention; however, in contrast to the relatively thick anti-reflective layer of the prior art resist, the anti-reflective layer of the present invention is "thin", in the same sense as the silicon nitride and resist layers of the prior art are "thin". The provision of a thin anti-reflective layer allows the production of sharper, substantially completely revable images on the substrate and substantially eliminates the effect of reflected light, to produce clear, sharply defined etched structures in the substrate.

We have now discovered an improved photolithographic process for integrated circuits, an improved anti-reflective material for use therein and an integrated circuit chip utilizing such material. The present process uses an anti-reflective coating that eliminates deleterious effects due to internal reflections from wafer surfaces and photoresist surfaces. The material offers better adhesion, greater light absorption, is a thinner, more uniform coating, and has a more controlled development and requires fewer process steps than those previously known. Also, it is compatible with and images with the photoresist, in the integrated circuit manufacturing process. The coating leaves less residue on the integrated circuit wafers after development.

The present invention thus consists in a photolithographic resist comprising a substrate, a photoresist and a light-absorbing imageable anti-reflective coating between said substrate and said photoresist, characterized in that said anti-reflective coating is a thin, essentially continuous layer of a polybutene sulphone, preferably a polybutene-1-sulphone, containing a dye, the anti-reflective coating being imageable by light of the same wavelength as the photoresist is imageable and being developable and removable with the photoresist.

The present invention further consists in a process for preparing said photolithographic resist, in which the anti-reflective coating is deposited and fixed to the substrate by depositing on the substrate a continuous layer of a solution of said polybutene sulphone and baking the product to remove said solvent and fix the resin to the substrate, wherein said solvent is a low surface energy solvent.

The invention further consists in a process for making an integrated circuit element by photolithography in which a pattern is imaged in the photoresist and anti-reflective coating of a resist as defined above, the anti-reflective coating imaging with the photoresist, developing and removing the developed image from the photoresist and anti-reflective coating, the imaged anti-reflective coating developing with and being removed with the photoresist, and etching a pattern defined by the imaged anti-reflective coating and photoresist into the substrate to produce said integrated circuit element.

The invention still further consists in a solution of a polybutene sulphone and a photolithographic dye in a solvent which is an alcohol, an aromatic hydrocarbon, a ketone or an ester or a mixture of any two or more thereof.

The invention is further illustrated with reference to the accompanying drawings, in which:

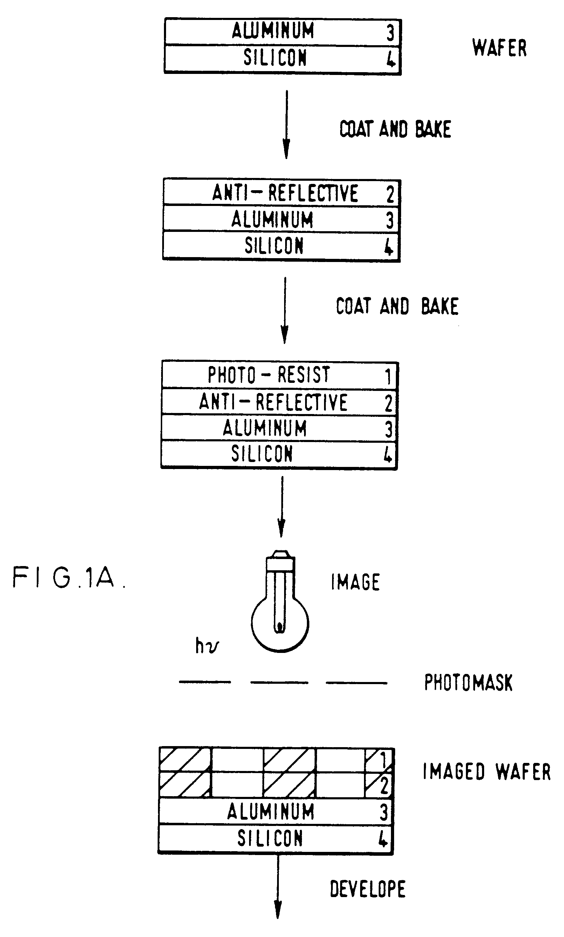

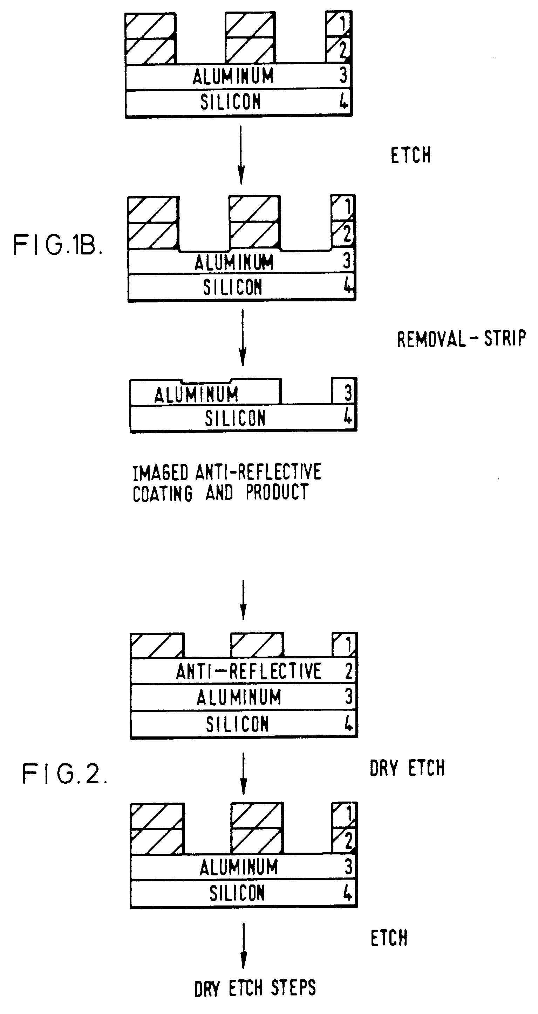

Figure 1 shows a process flow for producing an integrated circuit element using an imageable anti-reflective coating; and

Figure 2 shows modified process steps using a dry etch.

The present invention uses a particular polymer, which is such as to allow the use of common organic solvents having low surface (interfacial) energy, which can produced a firmly bonded, thin and consistent coating on a wafer surface. Suitable solvents having low surface energy include alcohols, aromatic hydrocarbons, ketones and ester solvents.

It has previously been attempted to produce anti-reflective coatings which had incorporated polymers of 4,4'-oxydianiline and benzophenone tetracarboxylic acid dianhydride and pyromellitic dianhydride, but these materials have not been effective at producing a satisfactory anti-reflective coating. The standard solvents for these polyimide precursors have large surface energies and do not penetrate into small depressions so that many areas of an integrated circuit chip are left uncoated due to the topographical variations of the substrate. The traditional solvents necessary for these previously attempted materials have been highly polar solvents, such as N-methyl pyrrolidinone, dimethyl formamide, and dimethyl sulphoxide. These solvents, which are required for dissolving the above polyamic acids, have very high surface energies, so that small depressions or troughs, common in the surface of integrated circuit chips, are not coated. By eliminating or greatly reducing the proportion of these highly polar solvents, having such high surface energy, and exploiting a system soluble in lower surface energy solvents such as alcohols, aromatic hydrocarbons, ketones or ester solvents, the surface energy of the solution is reduced, allowing the entire wafer surface to be coated and planarized. A further development in applicants' anti-reflective layer is the optional incorporation of water soluble components in the layer. These components may be, for example, polyvinyl pyrrolidinones, and equivalent polymers. The water soluble components reduce the variations in the rate of removal of the anti-reflective layer which are introduced by variations in the baking conditions, e.g. temperature.

Applicants' new material may also incorporate improved dye compounds into the reflective layer. In particular the use of the dye curcumin (colour index number 75300) or equivalent derivatives, and combinations thereof, to the anti-reflective coating improves the absorption performance of the coating. These, and related dyes, absorb strongly in the region of the spectrum (436, 405 nm), where the overlying photoresist is normally exposed and can be removed with the alkaline photoresist developer commonly used, e.g. because of the dye's hydroxyl groups. The combination allows rapid consistent imaging. The dye's excellent solubility in the coating solvents and the dye's strong absorption allow very thin coatings to be used. Coatings which had been attempted, using other dyes, have not had large extinction coefficients, that is, they do not absorb as much light per dye molecule or they are not sufficiently soluble in the organic solvents used for coating, a common problem with many dyes. Due to the dye's limited solubility, not enough could be coated to absorb essentially all the reflected light and its effects, such as standing waves, were still present in the photoresist. Moreover, prior dye-vehicle combinations were not effective to produce an imageable layer, as is the Applicants'. Prior attempts at producing imageable layers resulted in products which were ineffective due to defects in the coating produced, such as pinholes. The prior coatings were unreliable at imaging, had inconsistent and unreliable process characteristics, such as having narrow temperature bake latitude, and in leaving undesirable residue after processing. Attempts to accommodate these defects by use of thicker coatings were not effective. Applicants' coating is effective at imaging and does not require a thick coating or leave undesirable residue behind.

Applicants' anti-reflective coating can be made further effective by the optional additions of bixin (annatto extract) or other equivalent derivatives such as norbixin to the anti-reflective layer. Like curcumin derivatives, these dyes absorb strongly in the region of the spectrum at which the photoresist is exposed. These dyes are also readily removed by resist developer, and the carboxylic acid group and other features of these dyes decreases the variations in the rate of removal of the anti-reflective layer due to changes in the baking temperature.

Applicants' anti-reflective coating may also be produced in a dry etchable form which also allows patterned images to be formed in the manufacturing process. In this form, the vehicle that is used is rapidly removed by dry processing, that is plasma, ion or electron beams. When the photoresist is imaged, that image is easily and rapidly transferred into the anti-reflective layer by submitting the system to a short dry etch. In previous attempts to produce anti-reflective layers, attempts were made to use a middle layer (a third layer of a material that is not readily removed by a plasma) in order to produce a dry etch imaging. A system using two layers was also attempted, in which the photoresist was etched and entirely or mostly removed. In this second method the underlying planarizing layer does not etch fast enough to prevent the simultaneous etching of the photoresist.

Applicants' dry etchable anti-reflective coating is a relatively thick polymeric layer that planarizes the surface of the wafer and absorbs light that passes through the photoresist. No intermediate etch resistant layer is required, because the light-absorbing planarizing layer is very rapidly removed by dry processes without significant loss of the patterned photoresist layer.

The fast etching anti-reflective layer may use the dyes described above. The dyes may be any soluble dye or combination of dyes that has a suitable absorption and is easily removed by a dry process. For example, coumarins and derivatives thereof and equivalent halogenated dyes may be used and are also effective to form an imageable anti-reflective layer. The dry etch imageable anti-reflective coating adds a significant advance in geometry control without adding extra processing steps that lower yield and increase cost. The invention is compatible with photoresist materials and equipment.

Typically the dyes used by applicants are those that absorb in the wave length region of the imaging source. The dyes may be included in the anti-reflective coating at a level of from between about 1% to 20%. The film-forming vehicle, the polymer, may be present at a level of between about 3% to 20%. The optional addition of water soluble materials may be in concentrations of from between about 0.1% to 10%. The appropriate wetting agents, adhesion promoters, preservatives, plasticizers, and similar additives may be incorporated at the appropriate levels, if desired, and solvent incorporated to balance the composition to 100%.

The invention may be used in processes incorporating known techniques of coating substrates, such as spinning to produce film thickness from about 500 angstroms to 40,000 angstroms. The films may be baked at temperatures compatible with existing integrated circuit processes, for example, from about 70°C to 200°C. The baked film may be coated and baked with a photoresist as is known in the art. The photoresist thickness may be whatever is required by the process. These layers are then exposed with light of the known required wavelengths. The films may be developed at the same time with photoresist developer for a time, for example, from about 5 seconds to 5 minutes, or the photoresist may be developed and the underlying film may be removed with a short plasma etch cycle, for example, in an oxygen plasma or other standard plasma process for a period of from about 5 seconds to 5 minutes. The remaining integrated circuit element process may be conducted as prescribed by the known art. The films may be removed by standard photoresist cleanup processes.

The invention is further illustrated by the following examples which are included for purposes of illustration from the thousands of actual experiments which have been conducted. The imaged wafers produced have been routinely examined under an electron microscope. The examinations have revealed that the standing wave effect produced by reflected light has been eliminated.

EXAMPLE 1

Using the following anti-reflective coating formulation:

8.00 weight per cent poly(butene sulphone)

1.00 weight per cent coumarine 504 (Exciton Co., Dayton, Ohio)

cyclopentanone solvent (to balance)

a 3 inch (7.6 cm) aluminium-silicon wafer was coated with the anti-reflective coating, using a standard spin coating method, to an average thickness of 2.0 microns. The coated wafer was baked at 140°C for 60 minutes to cure the coating. The coated wafer was allowed to cool and was coated with a photoresist (Shipley AZ1370) by spin coating. The photoresist was cured by baking at 95°C for 30 minutes. The prepared wafer was imaged, using a test resolution pattern and a Cobilt contact printer. The imaged wafer was immersion developed using Shipley's MF312 developer for 20 seconds. The exposed photoresist was removed by the developer and produced a sharp, clear image. The anti-reflective layer was removed by an oxygen plasma (0.2. torr, 100 watts, 20 seconds), while the unexposed photoresist remained with almost no loss in thickness. The image was etched into the substrate of aluminium to produce a sharp pattern of an integrated circuit layer and the remaining photoresist and anti-reflective coating were removed.

EXAMPLE 2

Using the following anti-reflective coating formulation

6.00 weight % poly(butene sulphone)

1.00 weight % of the halogenated dye coumarin 540A (Exciton Co., Dayton, Ohio)

cyclopentanone solvent (to balance)

a 3 inch aluminium-silicon wafer was coated with the anti-reflective coating, using a standard spin coating method, to an average thickness of 1.5 microns. The coated wafer was baked at 140°C for 60 minutes to cure the coating. The coated wafer was allowed to cool and was coated with a photoresist (Shipley AZ1370) by spin coating. The photoresist was cured by baking at 95°C for 30 minutes. The prepared wafer was imaged, using a test resolution pattern and a Cobilt contact printer. The imaged wafer was immersion developed using Shipley's AZ350 developer for 20 seconds. The exposed photoresist was removed by the developer and produced a sharp clear image. The anti-reflective layer was removed by an oxygen plasma (0.2 torr, 100 watts, 20 seconds), while the unexposed photoresist remained with almost no loss in thickness. The image was etched into the substrate of aluminium to produce a sharp pattern of an integrated circuit layer and the remaining photoresist and anti-reflective coating were then removed.

## Claims

1. A photolithographic resist comprising a substrate, a photoresist and a light-absorbing imageable anti-reflective coating between said substrate and said photoresist, characterized in that said anti-reflective coating is a thin, essentially continuous layer of a polybutene sulphone containing a dye, which is highly soluble in at least one of an aromatic hydrocarbon, a ketone or an ester, or a mixture of any two or more thereof, the anti-reflective coating being imageable by light of the same wavelength as the photoresist is imageable and being developable and removable with the photoresist.

2. A resist according to Claim 1, wherein the anti-reflective coating is wet etchable.

3. A resist according to Claim 1, wherein the anti-reflective coating is dry etchable.

4. A resist according to Claim 1, wherein the anti-reflective coating contains at least one dye selected from curcumin and its derivatives, bixin and its derivatives, coumarin derivatives and equivalent organic halogenated, hydroxylated and carboxylated dyes and combinations thereof.

5. A process for preparing a photolithographic resist as claimed in any one of the preceding Claims, in which the anti-reflective coating is deposited and fixed to the substrate by depositing on the substrate a continuous layer of a solution of said polybutene sulphone and baking the product to remove said solvent and fix the resin to the substrate, wherein said solvent is a low surface energy solvent.

6. A process according to Claim 5, in which said solvent is an alcohol, an aromatic hydrocarbon, a ketone or an ester or a mixture of any two or more thereof.

7. A process according to Claim 5 or claim 6, wherein the photoresist and anti-reflective layer are simultaneously imaged.

8. A process according to any one of Claims 5 to 7, wherein the photoresist and anti-reflective layer are developed simultaneously.

9. A process for making an integrated circuit element by photolithography in which a pattern is imaged in the photoresist and anti-reflective coating of a resist as claimed in any one of Claims 1 to 4, the anti-reflective coating imaging with the photoresist, developing and removing the developed image from the photoresist and anti-reflective coating, the imaged anti-reflective coating developing with and being removed with the photoresist, and etching a pattern defined by the imaged anti-reflective coating and photoresist into the substrate to produce said integrated circuit element.

## Patentansprüche

1. Photolithographischer Resist, der ein Substrat, einen Photoresist und zwischen dem Substrat und dem Photoresist eine lichtabsorbierende, mit einem Abbild versehbare Antireflexionsbeschichtung umfaßt, dadurch gekennzeichnet, daß die Antireflexionsbeschichtung eine dünne, im wesentlichen kontinuierliche Schicht aus einem einen Farbstoff enthaltenden Polybutensulfon ist, das mindestens in einem aromatischen Kohlenwasserstoff, einem Keton, einem Ester oder einer Mischung von zwei oder mehreren derselben gut löslich ist, wobei die Antireflexionsbeschichtung durch Licht mit der gleichen Wellenlänge wie der Photoresist mit einem Abbild versehbar und mit dem Photoresist entwickelbar und entfernbar ist.

2. Resist nach Anspruch 1, bei dem die Antireflexionsbeschichtung naß ätzbar ist.

3. Resist nach Anspruch 1, bei dem die Antireflexionsbeschichtung trocken ätzbar ist.

4. Resist nach Anspruch 1, bei dem die Antireflexionsbeschichtung mindestens einem Farbstoff ausgewählt aus Curcumin und seinen Derivaten, Bixin und seinen Derivaten, Cumarinderivaten und äquivalenten organischen halogenierten, hydroxylierten und carboxylierten Farbstoffen sowie Kombinationen derselben enthält.

5. Verfahren zur Herstellung eines photolithographischen Resists gemäß einem der vorhergehenden Ansprüche, bei dem die Antireflexionsbeschichtung auf das Substrat aufgebracht und darauf fixiert wird, indem auf das Substrat eine kontinuierliche Schicht einer Lösung des Polybutensulfons aufgebracht und das Produkt gebacken wird, um das Lösungsmittel zu entfernen und das Harz an dem Substrat zu fixieren, wobei das Lösungsmittel ein Lösungsmittel mit niedriger Oberflächenenergie ist.

6. Verfahren nach Anspruch 5, bei dem das Lösungsmittel ein Alkohol, ein aromatischer Kohlenwasserstoff, ein Keton, ein Ester oder eine Mischung von zwei oder mehreren derselben ist.

7. Verfahren nach Anspruch 5 oder Anspruch 6, bei dem der Photoresist und die Antireflexionsschicht gleichzeitig mit einem Abbild versehen werden.

8. Verfahren nach einem der Ansprüche 5 bis 7, bei dem der Photoresist und die Antireflexionsschicht gleichzeitig entwickelt werden.

9. Verfahren zur Herstellung eines integrierten Schaltelements durch Photolithographie, bei dem in den Photoresist und die Antireflexionsbeschichtung von einem Resist gemäß einem der Ansprüche 1 bis 4 ein Muster abgebildet wird, wobei die Antireflexionsbeschichtung zusammen mit dem Photoresist mit dem Abbild versehen, das Abbild entwickelt und das entwickelte Abbild von dem Photoresist und der Antireflexionsbeschichtung entfernt wird, wobei die mit einem Bild versehene Antireflexionsbeschichtung zusammen mit dem Photoresist entwickelt und entfernt wird, und in das Substrat ein durch die mit einem Abbild versehene Antireflexionsschicht und den mit einem Abbild versehenen Photoresist definiertes Muster geätzt wird, um das integrierte Schaltelement herzustellen.

**Revendications**

1. Un résist photolithographique comprenant un substrat, un photorésist et un revêtement antiréfléchissant enregistrable à absorption de lumière entre ledit substrat et ledit photorésist, caractérisé en ce que ledit revêtement antiréfléchissant est une couche fine, essentiellement continue, d'un polybutène-sulfone contenant un colorant, hautement soluble dans au moins un hydrocarbure aromatique, une cétone ou un ester ou un mélange de deux de ces substances ou de plusieurs de celles-ci, le revêtement antiréfléchissant pouvant être enregistré par de la lumière de la même longueur d'onde que celle permettant l'enregistrement du photorésist et pouvant être développé et enlevé avec le photorésist.

2. Un résist selon la revendication 1, dans laquelle le revêtement antiréfléchissant peut être gravé au mouillé.

3. Un résist selon la revendication 1, dans laquelle le revêtement antiréfléchissant peut être gravé à sec.

4. Un résist selon la revendication 1, dans laquelle le revêtement antiréfléchissant contient au moins un colorant choisi parmi la curcumine et ses dérivés, la bixine et ses dérivés, les dérivés de la coumarine ainsi que des colorants organiques équivalents halogénés, hydroxylés et carboxylés et des combinaisons de ceux-ci.

5. Un procédé pour préparer un résist photolithographique selon l'une quelconque des revendications précédentes, dans lequel le revêtement antiréfléchissnt est déposé et fixé sur le substrat par dépôt sur le substrat d'une couche continue d'une solution du dit polybutène-sulfone et par séchage au four du produit en vue d'enlever ledit solvant et de fixer la résine sur le substrat, et dans lequel ledit solvant est un solvant à faible énergie superficielle.

6. Un procédé selon la revendication 5, dans lequel ledit solvant est un alcool, un hydrocarbure aromatique, une cétone ou un ester ou bien un mélange de deux de ces substances ou de plusieurs de celles-ci.

7. Un procédé selon la revendication 5 ou la revendication 6, dans lequel le photorésist et la couche antiréfléchissante sont enregistrés simultanément.

8. Un procédé selon l'une quelconque des revendications 5 à 7, dans lequel le photorésist et la couche antiréfléchissante sont développés simultanément.

9. Un procédé pour produire un élément de circuit intégré par photolithographie dans lequel une configuration est enregistrée dans le photorésist et le revêtement antiréfléchissant d'un résist selon l'une quelconque des revendications 1 à 4, le revêtement antiréfléchissant étant enregistré avec le photorésist, l'image étant développée et l'image développée étant enlevée du photorésist et du revêtement antiréfléchissant, le revêtement antiréfléchissant enregistré étant développé et enlevé ensemble avec le photorésist, une configuration définie par le revêtement antiréfléchissant et le photorésist enregistrés étant gravée dans le substrat pour produire ledit élément de circuit intégré.

| ALUMINUM | 3 |
|---|---|
| SILICON | 4 |

WAFER

COAT AND BAKE

| ANTI-REFLECTIVE | 2 |
|---|---|
| ALUMINUM | 3 |
| SILICON | 4 |

COAT AND BAKE

| PHOTO-RESIST | 1 |
|---|---|
| ANTI-REFLECTIVE | 2 |
| ALUMINUM | 3 |
| SILICON | 4 |

FIG.1A.

IMAGE

hυ

PHOTOMASK

| | 1 |
|---|---|
| | 2 |
| ALUMINUM | 3 |
| SILICON | 4 |

IMAGED WAFER

DEVELOPE

FIG.1B.

ETCH

REMOVAL – STRIP

IMAGED ANTI-REFLECTIVE
COATING AND PRODUCT

FIG.2.

DRY ETCH

ETCH

DRY ETCH STEPS